(19) Europäisches Patentamt
European Patent Office
Office européen des brevets

(11) **EP 2 652 808 B1**

(12) **FASCICULE DE BREVET EUROPEEN**

(45) Date de publication et mention
de la délivrance du brevet:
**21.10.2020 Bulletin 2020/43**

(21) Numéro de dépôt: **11807776.7**

(22) Date de dépôt: **14.12.2011**

(51) Int Cl.:
***H01L 45/00*** *(2006.01)*

(86) Numéro de dépôt international:
**PCT/IB2011/055672**

(87) Numéro de publication internationale:
**WO 2012/080967 (21.06.2012 Gazette 2012/25)**

(54) **ELEMENT MEMRISTIF ET MEMOIRE ELECTRONIQUE BASEE SUR DE TELS ELEMENTS.**

MEMRISTIVES ELEMENT UND ELEKTRONISCHER SPEICHER AUF BASIS DERARTIGER ELEMENTE

MEMRISTIVE ELEMENT AND ELECTRONIC MEMORY BASED ON SUCH ELEMENTS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **17.12.2010 FR 1004931**

(43) Date de publication de la demande:
**23.10.2013 Bulletin 2013/43**

(73) Titulaires:
• **Centre National de la Recherche Scientifique**
**75016 Paris (FR)**
• **Commissariat à l'Énergie Atomique**
**et aux Énergies Alternatives**
**75015 Paris (FR)**
• **Université Paris-Saclay**
**91190 Saint-Aubin (FR)**

(72) Inventeurs:
• **MORADPOUR, Alexandre**
**F-75016 Paris (FR)**
• **SCHNEEGANS, Olivier**
**F-92160 Antony (FR)**
• **REVCOLEVSCHI, Alexandre**
**F-92100 Boulogne (FR)**
• **SALOT, Raphaël**
**F-38250 Lans-en-vercors (FR)**
• **FRANGER, Sylvain**
**F-91190 Gif Sur Yvette (FR)**

(74) Mandataire: **Lavoix**
**2, place d'Estienne d'Orves**
**75441 Paris Cedex 09 (FR)**

(56) Documents cités:
**WO-A1-2009/122567    WO-A1-2010/014064**
**US-A1- 2010 102 289**

• **L. CHUA: "Memristor-The missing circuit element", IEEE TRANSACTIONS ON CIRCUIT THEORY, vol. 18, no. 5, 1 janvier 1971 (1971-01-01), pages 507-519, XP055002642, ISSN: 0018-9324, DOI: 10.1109/TCT.1971.1083337**

EP 2 652 808 B1

**Description**

L'invention porte sur un élément mémristif, ainsi que sur une mémoire électronique de type non-volatile basée sur l'utilisation d'une pluralité de tels éléments.

Le concept de « mémristor » a été introduit en 1971 par L. O. Chua dans l'article « Memristor - The Missing Circuit Element », IEEE Transactions on Circuit Theory, Vol. CT-18, 1971, pages 507-519.

Sur le plan conceptuel, un mémristor est défini comme un élément (plus exactement, un dipôle électrique) dans lequel le flux magnétique $\Phi_B$ est une fonction de la charge électrique q ayant traversé l'élément. La « mémristance » M(q) est définie par :

$$M(q) = \frac{d\Phi_B}{dq}$$

Il est possible de démontrer qu'il suit de cette définition que :

$$V(t) = M(q(t))I(t)$$

où V(t) est la tension aux bornes du dipôle et I(t) le courant le traversant, exprimés en fonction du temps t. Autrement dit, à chaque instant M(q) équivaut à une résistance dont la valeur varie en fonction de q, et donc de l' « histoire » du courant I (on ne considère pas ici le cas banal où M(q)=R constant, et le mémristor se réduit à une résistance ordinaire).

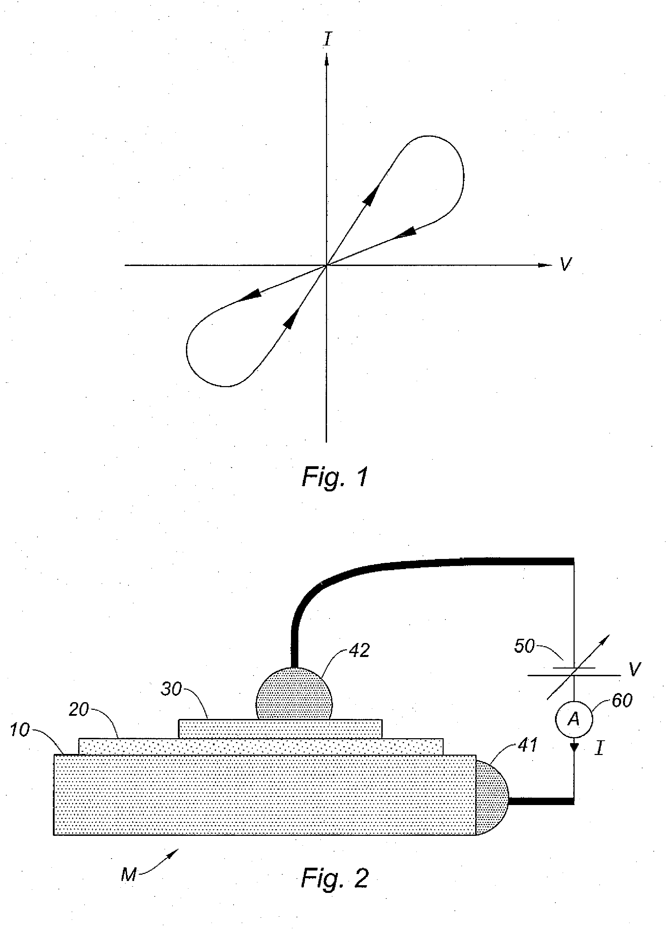

Si l'on trace, dans un plan V-I, la caractéristique d'un mémristor, on obtient en général une courbe présentant un double cycle d'hystérésis, comme illustré sur la figure 1.

En raison de la forme de leur caractéristique, certains mémristors présentent un comportement bistable et peuvent servir en tant qu'éléments de mémoire non volatile. L'application d'une tension aux bornes d'un tel dispositif provoque une forte variation de sa résistance, par exemple, son passage d'une valeur élevée - représentant une valeur logique « 1 » à une valeur faible, représentant une valeur « 0 ». Comme la caractéristique présente une hystérésis, cette valeur de résistance se maintient lorsque la tension descend à zéro ; il faut l'application d'une tension inverse pour revenir à la valeur initiale (élevée) de résistance.

Ce comportement bistable permet aussi d'utiliser des matrices de mémristors pour réaliser des opérations logiques. Voir à ce propos l"article de J. Borghetti et al. « 'Memristive' switches enable 'stateful' logic operations via material implication », Nature, Vol. 464, pages 873 - 876, 8 avril 2010.

Un comportement pouvant être qualifié de « mémristif » de certains matériaux, et notamment de couches minces de $TiO_2$, était déjà connu de la communauté des électrochimistes depuis les années 1960 - c'est-à-dire avant même la formulation du concept de « mémristor » : voir l'article de F. Abgall « Switching phenomena in titanium oxide thin films », Solid-State Electronics 1968. Vol. 11, pages 535-541.

La réalisation d'un élément électronique qualifiable de « mémristor » a été décrite pour la première fois dans l'article de D. B. Strukov et al. « The missing memristor found », Nature, Vol. 453, pages 80 - 83, 1er mai 2008. Cet élément utilise comme matériau actif une bicouche $TiO_2/TiO_{2-x}$. Voir aussi les documents US 2008/0079029, US 7,763,880 et US 7,417,271, qui envisagent également une possible généralisation à d'autres oxydes, éventuellement de composition relativement complexe.

Le changement de résistivité à la base du comportement mémristif de ces éléments de l'art antérieur est provoqué par la migration, induite par un champ électrique, d'espèces dopantes - et en particulier de lacunes d'oxygène - d'une première couche conductrice qui en est riche vers une deuxième couche qui en est dépourvue, et qui est de ce fait moins conductrice. L'inconvénient de ces dispositifs est la relative complexité de fabrication de la structure bicouche (voire, dans certains cas, multicouche).

Le dispositif décrit dans l'article précité de J. Borghetti et al. comporte, quant à lui, une seule couche de $TiO_2$ prise en sandwich entre deux couches métalliques. Il est connu que dans une telle structure les espèces dopantes (lacunes d'oxygène) forment des filaments conducteurs entre les deux électrodes métalliques ; voir à ce propos les articles de R. Waser « Nanoionics-based resistive switching memories », Nature materials, Vol. 6, pages 833 - 840, novembre 2007, et « Redox-Based Resistive Switching Memories - Nanoionic Mechanisms, Prospects, and Challenges », Advanced Materials 21, pages 2632 - 2663, 2009. La croissance de ces filaments conducteurs est un phénomène aléatoire, ayant lieu le long de dislocations du réseau. Il est donc difficile d'assurer la présence d'au moins un de ces filaments dans un dispositif de dimensions nanométriques, qui ne pourrait donc pas fonctionner de manière fiable. Par conséquent, un mécanisme de commutation de résistance basé sur la formation de chemins conducteurs filamentaires est intrinsèquement de nature à limiter la miniaturisation des dispositifs.

Il faut également souligner que la formation initiale de ces filaments conducteurs nécessite une étape préalable « d'électroformage » des films, qui est encore peu comprise et donc difficilement contrôlable (J. J.Yang et al., Nanotechnol., 2009, 20, 215201).

Le document WO 2010/074689 fait état de dispositifs mémristifs comprenant une région active unique, réalisée en un matériau comprenant au moins deux espèces mobiles. Plusieurs familles de matériaux de ce type sont mentionnées, parmi lesquels des composés de substitution, où des atomes de métal alcalin remplacent des atomes de métal de transition pour former des défauts interstitiels qui agissent en tant que dopants. Il semblerait qu'une étape d'électroformage soit également nécessaire pour assurer le fonctionnement de ces dispositifs (voir l'article précité de J.Yang et al.).

Le document US 2010/102289 décrit un élément de mémoire de type résistif dont la région active comprend deux couches métalliques ou en oxyde métallique, dont une est dopée avec une espèce porteuse de charge, séparées par une couche intermédiaire réalisée en un matériau différent de celui ou ceux des deux autres couches. La réalisation d'un tel dispositif est complexe.

Le document WO 2009/122567 décrit un élément mémristif comprenant une région active constituée d'une couche mince. Il s'agit de composés d'insertion d'au moins un métal de transition, de type oxyde ou nitrure. Le comportement mémristif de ces dispositifs nécessite la création de chemins de transfert dans la structure cristalline de la région active. La réalisation d'un tel dispositif est également complexe.

Le document WO2008/145864 décrit l'utilisation, pour la réalisation de mémoires de masse, de composés d'insertion d'au moins un métal alcalin, de type oxyde ou chalcogénure d'au moins un métal de transition, présentant une conductivité de nature à la fois électronique et ionique et, le plus souvent, une structure lamellaire. Certains de ces matériaux, tels que $Na_xCoO_2$ et $Li_xCoO_2$ ($0<x\leq1$) sont connus en tant que matériaux pour la réalisation d'accumulateurs électrochimiques. Voir par exemple le document EP 1 860 713.

Les mémoires de masse décrites par le document WO2008/145864 précité comprennent un substrat massif monocristallin d'un tel matériau, au-dessus duquel se trouve une pointe de microscope à force atomique (AFM). Un ménisque d'eau se forme spontanément entre la pointe et la surface du substrat ; ce ménisque assure la conduction électrique entre ces deux éléments et forme une cellule électrochimique dans laquelle peuvent se produire des réactions d'oxydoréduction. Et ce sont justement des réactions électrochimiques de ce type, induites par l'application d'une différence de potentiel entre la pointe d'AFM et le substrat, qui sont à la base du fonctionnement de la mémoire de masse.

En effet, le changement du nombre d'oxydation d'un atome de métal de transition s'accompagne de l'expulsion vers la surface d'un atome inséré (ou « intercalé », les deux notions étant équivalentes) de métal alcalin ou, inversement, de son rappel vers le cœur du substrat, ce qui produit un changement réversible de la conductivité de surface. Voir à ce propos les articles suivants :

- O. Schneegans, A. Moradpour, O. Dragos, S. Franger, N. Dragoe, L. Pinsard-Gaudart, P. Chretien, A. Revcolevschi, J. Amer. Chem. Soc, 2007, 129, 7482.
- O. Schneegans, A. Moradpour, L. Boyer, D. Ballutaud, J. Phys. Chem. B, 2004, 108, 9882.

De telles mémoires sont très difficiles et couteuses à mettre en œuvre : les substrats monocristallins sont difficiles à fabriquer et, pour certains tel que $Na_xCoO_2$, instables à l'air ; l'utilisation de pointes d'AFM introduit une complexité considérable et rend nécessaire une tête de lecture balayant la surface du substrat.

L'invention vise à surmonter les inconvénients précités de l'art antérieur.

Les présents inventeurs ont démontré que des couches minces - même non monocristallines - de ces composés d'insertion d'au moins un métal alcalin, de type oxyde ou chalcogénure d'au moins un métal de transition, en contact électrique direct avec deux électrodes, présentent un comportement mémristif très marqué. Cela permet la réalisation de matrices d'éléments résistifs de type « à barres croisées » (« crossbar »), de structure très simple et sans parties en mouvement. Par ailleurs, des couches minces polycristallines ou amorphes sont beaucoup plus simples et économiques à fabriquer que des substrats monocristallins. La miniaturisation peut être très poussée (cellules de mémoire de dimensions nanométriques), et le temps d'écriture de la mémoire très court (nanosecondes). En effet, les changements de conductivité électrique mettent en œuvre des déplacements d'ions de métaux alcalins, et en particulier d'ions $Li^+$ ou $Na^+$, qui sont de petites dimensions et donc beaucoup plus mobiles que les lacunes d'oxygène responsables du comportement mémristif des couches de $TiO_2$. Le changement de conductivité de ces matériaux n'est pas provoqué par la formation de filaments, et aucun électroformage préalable n'est nécessaire.

Il importe de noter que le principe de fonctionnement de ces dispositifs - imparfaitement connu à cette date - est fondamentalement différent de celui de la mémoire de masse du document WO2008/145864 précité en raison de la nature différente du matériau actif (couche mince au lieu d'un substrat massif monocristallin) et de l'absence de ménisque d'eau.

Un objet de l'invention est donc un élément mémristif formé par : une première électrode, une deuxième électrode, et une région active en contact électrique direct avec lesdites première et deuxième électrodes, caractérisé en ce que ladite région active est constituée exclusivement par une couche mince d'un composé d'insertion d'au moins un métal alcalin, de type oxyde ou chalcogénure d'au moins un métal de transition, présentant une conductivité de nature à la fois électronique et ionique.

Selon différents modes de réalisation de l'invention :

- Ladite couche mince peut être déposée sur une surface de ladite première électrode.
- Ladite première électrode peut être choisie parmi une surface d'un substrat semi-conducteur dégénéré et une couche métallique déposée sur un substrat isolant.
- Ladite deuxième électrode peut être formée par une couche métallique déposée sur ladite couche mince.
- Ladite couche mince peut présenter une structure polycristalline ou amorphe. L'expression « polycristalline » doit être entendue au sens large, couvrant les cas d'une couche microcristalline, nanocristalline ou constituée de cristallites liées entre elles par une matrice amorphe.
- Ladite couche mince peut présenter une épaisseur inférieure ou égale à 10 $\mu$m, et de préférence comprise entre 5 nm et 1 $\mu$m.
- Ledit composé d'insertion d'au moins un métal alcalin, de type oxyde ou chalcogénure d'au moins un métal de transition, peut répondre à la formulation suivante : $A_x(M_1)_v(M_2)_w(M_3)_y(M_4)_z B_\beta$.

où :

- A représente un ou plusieurs métaux alcalins ;
- $M_1$ représente au moins un métal choisi parmi Ag et Cu;
- $M_2$ représente au moins un métal choisi parmi Mg, Ca, Sr, Ba, Ti, Mn, Fe, Cu et Zn ;
- $M_3$ représente au moins un métal choisi parmi Al, Ti, V, Cr, Mn, Fe, Co, Ni, Mo et Ta ;
- $M_4$ représente au moins un métal choisi parmi Ti, V, Mn, Co, Ni, Zr, Sn et Ta ;
- B représente au moins un non-métal choisi parmi O, S, Se et Te ;
- les paramètres x, v, w, y, z et $\beta$ satisfont aux inégalités suivantes, x étant de plus choisi dans le domaine de stabilité des composés :

  - $0 < x \leq 1$
  - $0 \leq v \leq 1$
  - $0 \leq w < 1$
  - $0 \leq y \leq 1$
  - $0 \leq z < 1$
  - $1,5 \leq \beta$
- les paramètres x, v, w, y et z satisfont également à l'égalité : $v + w + y + z = 1$.

De préférence, en outre, $\beta \leq 10$ et d'une manière encore préférée $\beta \leq 5$.

Plus précisément, ledit composé d'insertion d'au moins un métal alcalin, de type oxyde ou chalcogénure d'au moins un métal de transition, peut répondre à la formulation suivante $A'_x M_y B_\beta$

où :

- A' représente au moins un métal alcalin choisi parmi Li et Na ;
- M représente au moins un métal choisi parmi Mn, Fe, Co et Ni ;
- B représente au moins un non-métal choisi parmi O et S ; et
- les paramètres x, y et $\beta$ satisfont aux inégalités suivantes, x étant de plus choisi dans le domaine de stabilité des composés :

  - $0 < x \leq 1$
  - $y = 1$
  - $1,5 \leq \beta$.
- Comme indiqué plus haut, de préférence, en outre, $\beta \leq 10$ et de manière encore préférée $\beta \leq 5$.

  - De manière encore plus précise, ledit composé d'insertion d'au moins un métal alcalin, de type oxyde ou chalcogénure d'au moins un métal de transition, peut être choisi parmi les suivants : $Na_x CoO_2$ $Li_x CoO_2$, $Li_x NiO_2$, $Li_x Mn_4 O_9$, $Li_x TiO_2$, $Li_{4+x} Ti_5 O_{12}$, $Li_x V_2 O_5$, $Li_x V_6 O_{13}$, $Li_x Ni_y Co_{(1-y)} O_2$, $Li_x FeO_2$, $Li_x MnO_2$ $Li_x Mn_2 O_4$, $Li_x MoO_3$ et $Li_x Ni_{1/3} Mn_{1/3} Co_{1/3} O_2$, le paramètre x étant choisi dans le domaine de stabilité de ces composés. On remarquera que certaines de ces formules ont été écrites dans une forme dans laquelle le paramètre y peut prendre une valeur supérieure à 1. Bien entendu, elles peuvent toujours être normalisées pour se reconduire au cas y=1.

- De manière préférentielle ledit composé d'insertion d'au moins un métal alcalin, de type oxyde ou chalcogénure d'au moins un métal de transition, peut être choisi parmi $Na_xCoO_2$ et $Li_xCoO_2$.
- Ledit composé d'insertion d'au moins un métal alcalin, de type oxyde ou chalcogénure d'au moins un métal de transition, peut présenter une structure lamellaire.
- Au moins une parmi ladite première et ladite deuxième électrode peut être réalisée en silicium. Dans un mode de réalisation préféré de l'invention, une (et une seule) parmi ladite première et ladite deuxième électrode est réalisée en silicium et ledit composé d'insertion d'au moins un métal alcalin est du $Li_xCoO_2$.
- En variante, au moins une parmi ladite première et ladite deuxième électrode peut être réalisée en un matériau choisi parmi l'aluminium, le gallium, l'indium, l'antimoine, le bismuth, le cadmium, le zinc, l'étain, le plomb.

Un autre objet de l'invention est une mémoire électronique de type non volatile constituée par une pluralité d'éléments mémristifs tels que décrits ci-dessus, agencés de façon matricielle selon des lignes et des colonnes, tous les éléments d'une même ligne partageant une première électrode commune, et tous les éléments d'une même colonne partageant une deuxième électrode commune.

D'autres caractéristiques, détails et avantages de l'invention ressortiront à la lecture de la description faite en référence aux dessins annexés donnés à titre d'exemples non limitatifs, dans lesquels :

- La figure 1, déjà décrite, illustre de manière générale la caractéristique tension-courant d'un mémristor ;
- La figure 2 montre, de manière schématique, un élément mémristif selon un mode de réalisation de l'invention ;
- La figure 3 montre, à l'échelle semi-logarithmique, la caractéristique tension-courant du dispositif de la figure 2 ; et
- Les figures 4A et 4B illustrent, de manière schématique, la structure d'une mémoire électronique selon un deuxième mode de réalisation de l'invention.

Le dispositif M de la figure 2 est constitué par un substrat 10 en silicium dégénéré avec un fort dopage de type n (en variante, un dopage de type p aurait pu être utilisé), présentant donc un comportement de type métallique et servant de première électrode, sur lequel est déposée une couche active de $Li_{0,9}CoO_2$ de 100 nm d'épaisseur, 20. Un plot d'or 30, de dimensions 100 $\mu$m x 400 $\mu$m est déposée sur la couche 20 pour former la deuxième électrode du dispositif. Deux contacts électriques 41, 42 sont réalisés sur le substrat 10 et sur le plot 30 afin de pouvoir appliquer une différence de potentiel variable V au moyen du générateur 50. Un ampèremètre 60 mesure le courant I circulant à travers le dispositif.

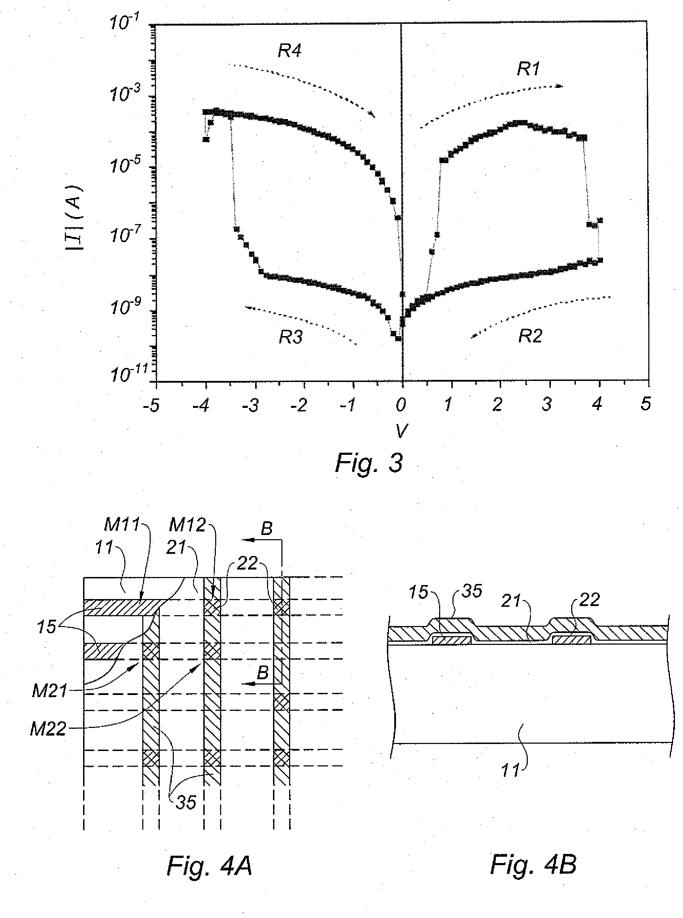

Le générateur 50 est utilisé pour appliquer une première rampe de tension de 0V à +4V (R1 sur la figure 3), puis une deuxième rampe de +4V à -4V (la première partie, de +4V à 0V, est indiquée par la référence R2 ; la deuxième partie, de 0V à -4V, est indiquée par R3), enfin une troisième rampe de -4V à 0V (R4). Les sens positifs de la tension et du courant sont représentés sur la figure 2. Le graphique de la figure 3 représente la valeur absolue du courant, à l'échelle logarithmique, en fonction de la tension, à l'échelle linéaire.

On peut voir sur la figure 3 qu'initialement, au début de la rampe R1, le courant augmente rapidement avec la tension, ce qui indique que la résistance du dispositif est relativement faible (quelques k$\Omega$) ; puis, au-dessus de 1V, le courant se stabilise, ce qui indique une augmentation progressive de la résistance, jusqu'à 25 k$\Omega$ environ. A 3,8 V environ, le courant chute brusquement d'environ trois ordres de grandeur, ce qui indique une transition de l'élément M d'un premier état de faible résistance (valeur de résistance variable en fonction de la tension, mais toujours inférieure ou égale à 25 k$\Omega$ environ) vers un deuxième état de haute résistance (de l'ordre de 10 M$\Omega$).

Lorsque la tension décroit (R2), puis devient négative (R3), la résistance du dispositif change peu, et reste au moins de l'ordre du M$\Omega$. Ce n'est que lorsque V atteint -3,5V qu'il se produit une nouvelle transition brusque, cette fois du deuxième état vers le premier.

La résistance de l'élément reste de l'ordre de quelques k$\Omega$/ dizaines de k$\Omega$ lorsque la tension revient vers zéro (R4). Le cycle peut être répété plusieurs fois.

Le dispositif de la figure 2 a été réalisé dans un but de validation de principe de l'invention ; comme il est de grandes dimensions, il présente un temps de commutation de l'ordre de la seconde. Un dispositif destiné à des applications commerciales pourrait avoir des dimensions beaucoup plus petites, de l'ordre de 10 nm x 10 nm, et des temps de commutation que l'on peut estimer par extrapolation être de l'ordre de quelques nanosecondes.

Des nombreuses variantes du dispositif de l'invention peuvent être envisagées.

Par exemple, la première et la deuxième électrode peuvent être réalisées toutes deux en métal, ou bien en semi-conducteur dégénéré. Elles peuvent notamment être des pistes métalliques, voire en polysilicium, déposées sur un substrat isolant ($SiO_2$ ; Si intrinsèque, etc.).

Il a été constaté que la différence de résistance électrique entre les deux états du dispositif mémristif est particulièrement élevée lorsque une des deux électrodes (par exemple, la première électrode 10 du dispositif de la figure 1) est réalisée en un matériau susceptible de former un alliage avec le (ou au moins un) métal alcalin de la couche active ; il peut s'agir du silicium, du l'aluminium, du gallium, de l'indium, de l'antimoine, du bismuth, du cadmium, du zinc, de l'étain, du plomb. Il a été constaté que, dans ce cas, les ions de métal alcalin pénètrent assez profondément (500 nm dans le cas du dispositif de la figure 2, où la première électrode est en silicium fortement dopé et le métal alcalin est le lithium) dans l'électrode ; bien que le mécanisme ne soit pas entièrement compris, cela semble jouer un rôle important dans la commutation de résistance.

L'autre électrode peut être réalisée en métal « noble », tel que l'or, le platine, etc. En raison de son inertie chimique, un tel matériau n'est pas impliqué dans les réactions électrochimiques qui se déroulent dans le volume actif. L'utilisation de deux électrodes en métal noble est possible, mais moins avantageuse.

Une telle configuration convient particulièrement bien à la réalisation de matrices de mémristors, comme cela sera discuté plus loin en référence aux figures 4A et 4B.

D'autres matériaux peuvent être utilisés pour la réalisation de la couche active 20, ces matériaux appartenant à la famille des composés d'insertion d'(au moins) un métal alcalin, de type oxyde ou chalcogénure d'(au moins) un métal de transition, présentant une conductivité de nature à la fois électronique et ionique et généralement une structure de type lamellaire.

Des matériaux convenant à la mise en oeuvre de l'invention sont caractérisés par la formule générale $A_x(M_1)_v(M_2)_w(M_3)_y(M_4)_z B_\beta$

où :

- A représente un ou plusieurs métaux alcalins ;
- $M_1$ représente au moins un métal pouvant prendre un nombre d'oxydation égal à 1, et plus particulièrement choisi parmi Ag et Cu.
- $M_2$ représente au moins un métal pouvant prendre un nombre d'oxydation égal à 2, et plus particulièrement choisi parmi Mg, Ca, Sr, Ba, Ti, Mn, Fe, Cu et Zn ;
- $M_3$ représente au moins un métal pouvant prendre un nombre d'oxydation égal à 3, et plus particulièrement choisi parmi Al, Ti, V, Cr, Mn, Co, Ni, Mo et Ta ;
- $M_4$ représente au moins un métal pouvant prendre un nombre d'oxydation égal à 4, et plus particulièrement choisi parmi Ti, V, Mn, Fe, Co, Ni, Zr, Sn et Ta ;
- B représente au moins un non-métal choisi en particulier parmi O, S, Se et Te.

Les paramètres x, v, w, y, z et $\beta$ doivent satisfaire aux inégalités suivantes : $0 < x \leq 1$ ; $0 \leq v \leq 1$ ; $0 \leq w < 1$ ; $0 \leq y \leq 1$ ; $0 \leq z < 1$ et $1,5 \leq \beta$. Ainsi, le paramètre x peut varier entre 0 (exclus, car la présence d'un métal alcalin est essentielle) et 1 (inclus), tandis que les paramètres v, w, y et z peuvent varier, individuellement, entre 0 (inclus) et 1 (inclus), leur somme (v + w + y + z) devant être égale à 1. Une autre contrainte sur les valeurs de v, w, y et z est qu'au moins un métal de transition doit être présent. De plus, x doit prendre une valeur permettant d'assurer la stabilité chimique du composé (les plages de stabilité du paramètre x dépendent de la composition qualitative du matériau). Le paramètre $\beta$ (bêta), quant à lui, est supérieur ou égal à 1,5 ; il est difficile de déterminer une limite supérieure à la valeur de ce paramètre ; dans la grande majorité des cas, cependant, cette valeur se maintiendra inférieure ou égale à 10, voire inférieure ou égale à 5.

D'une manière avantageuse, le matériau peut être caractérisé par la formule générale $A'_x M_y B_\beta$, où :

- A' représente au moins un métal alcalin choisi parmi Li et Na ;
- M représente au moins un métal choisi parmi Mn, Fe, Co et Ni;
- B représente au moins un non-métal choisi parmi O et S ;
- les paramètres x, y et $\beta$ satisfont aux inégalités suivantes, x étant de plus choisi dans le domaine de stabilité des composés :
  $0 < x \leq 1$ ; $y = 1$ (cette condition peut toujours être satisfaite par normalisation de la formule); $1,5 \leq \beta$.

En particulier on peut citer les matériaux suivants (formules non normalisées) : $Na_xCoO_2$ $Li_xCoO_2$, $Li_xNiO_2$, $Li_xMn_4O_9$, $Li_xTiO_2$, $Li_{4+x}Ti_5O_{12}$, $Li_xV_2O_5$, $Li_xV_6O_{13}$, $Li_xNi_yCo_{(1-y)}O_2$, $Li_xFeO_2$, $Li_xMnO_2$ $Li_xMn_2O_4$, $Li_xMoO_3$ et $Li_xNi_{1/3}Mn_{1/3}Co_{1/3}O_2$.

Les composés $Na_xCoO_2$ et $Li_xCoO_2$ sont particulièrement préférés.

L'épaisseur de la couche active est donnée à titre d'exemple uniquement. En général, on considère « mince » une couche d'épaisseur inférieure ou égale à 10 $\mu$m, et de préférence inférieure ou égale à 1 $\mu$m. L'épaisseur minimale acceptable dépend du matériau utilisé ; de manière indicative, l'épaisseur sera de préférence supérieure ou égale à 10 nm.

La figure 4A montre une vue en plan d'une matrice d'éléments mémristifs M11, M12, M21, M22 etc.... de dimensions nanométriques, et la figure 4B une vue en coupe, selon la ligne B-B, de cette même matrice.

Sur un substrat 11, de type isolant, sont déposées des pistes conductrices 15 (représentées en trait pointillée) formant les « premières électrodes » des éléments. Tous les éléments d'une même ligne de la matrice partagent une même première électrode (ou, ce qui est équivalent, ils pourraient avoir des premières électrodes connectées électriquement entre elles). Une couche 21 de matériau actif, ayant une épaisseur comprise, de manière préférentielle, entre 10 et 100 nm est déposée de manière continue au dessus du substrat 11 et des premières électrodes 15 (sur la figure, un coin de la couche 21 est arraché pour montrer les éléments qui se trouvent au-dessous). D'autres pistes conductrices 35, perpendiculaires aux lignes 15, sont déposées sur le substrat et sur les régions actives. Les volumes de la couche active qui se trouvent compris entre une piste conductrice inférieure 15 et une piste conductrice supérieure 25 forment les régions actives 22 des éléments de la matrice. Un dépôt localisé du matériau actif seulement au niveau des croisements entre les électrodes est également possible, et même préféré car il garantit une meilleure isolation - électrique et chimique - entre les éléments de la matrice ; cependant ce mode de réalisation est plus complexe à mettre en œuvre.

Pour les raisons expliquées plus haut, les pistes conductrices 15 et/ou 35 seront de préférence réalisées en un matériau conducteur susceptible de former un alliage avec le (ou au moins un) métal alcalin de la couche active - par exemple en silicium. L'utilisation du silicium est particulièrement préféré pour des raisons technologiques

On peut voir que tous les éléments d'une même ligne de la matrice partagent une même deuxième électrode formée par une piste 35 (de manière équivalente, ils pourraient avoir des premières électrodes connectées électriquement entre elles). On a ainsi une structure de type « à barres croisées », ou « crossbar » : l'application d'une différence de potentiel entre la i-ème ligne et la j-ème colonne permet de lire/écrire l'élément $M_{ij}$ de la mémoire. « Ecrire » signifie ici appliquer une différence de potentiel suffisamment importante pour provoquer une modification significative de la résistivité de l'élément ; « lire » signifie appliquer une différence de potentiel plus faible, mesurer la valeur du courant et en déduire la valeur de résistance, et donc l'état dans lequel se trouve l'élément.

Cette structure est conventionnelle, les dispositifs de l'invention peuvent également s'appliquer à d'autres architectures.

**Revendications**

1. Elément mémristif (M) formé par :

   - une première électrode (10) ;
   - une deuxième électrode (30) ; et
   - une région active (20) en contact électrique direct avec lesdites première et deuxième électrodes, **caractérisé en ce que** ladite région active est exclusivement constituée par une couche mince d'un composé d'insertion d'au moins un métal alcalin, de type oxyde ou chalcogénure, d'au moins un métal de transition présentant une conductivité de nature à la fois électronique et ionique.

2. Elément mémristif selon la revendication 1 dans lequel ladite couche mince est déposée sur une surface de ladite première électrode.

3. Elément mémristif selon l'une des revendications précédentes, dans lequel ladite première électrode est choisie parmi une surface d'un substrat semi-conducteur dégénéré et une couche métallique déposée sur un substrat isolant.

4. Elément mémristif selon l'une des revendications précédentes, dans lequel ladite deuxième électrode est formée par une couche métallique déposée sur ladite couche mince.

5. Elément mémristif selon l'une des revendications précédentes, dans lequel ladite couche mince présente une structure polycristalline ou amorphe.

6. Elément mémristif selon l'une des revendications précédentes, dans lequel ladite couche mince présente une épaisseur inférieure ou égale à 10 $\mu$m, et de préférence comprise entre 10 nm et 1 $\mu$m.

7. Elément mémristif selon l'une des revendications précédentes, dans lequel ledit composé d'insertion d'au moins un métal alcalin, de type oxyde ou chalcogénure d'au moins un métal de transition, répond à la formulation suivante :

$$A_x(M_1)_v(M_2)_w(M_3)_y(M_4)_z B_\beta$$

où :

- A représente un ou plusieurs métaux alcalins ;
- $M_1$ représente au moins un métal choisi parmi Ag et Cu ;
- $M_2$ représente au moins un métal choisi parmi Ti, Mn, Fe et Cu ;
- $M_3$ représente au moins un métal choisi parmi Ti, V, Cr, Mn, Fe, Co, Ni, Mo et Ta ;
- $M_4$ représente au moins un métal choisi parmi Ti, V, Mn, Co, Ni, Zr et Ta ;
- B représente au moins un non-métal choisi parmi O, S, Se et Te ;
- les paramètres x, v, w, y, z et $\beta$ satisfont aux inégalités suivantes, x étant de plus choisi dans le domaine de stabilité des composés :

$$0 < x \leq 1$$
$$0 \leq v \leq 1$$
$$0 \leq w < 1$$
$$0 \leq y \leq 1$$
$$0 \leq z < 1$$
$$1{,}5 \leq \beta$$

- les paramètres x, v, w, y, z satisfont également à l'égalité : v + w + y + z = 1.

8. Elément mémristif selon la revendication 7, dans lequel ledit composé d'insertion d'au moins un métal alcalin, de type oxyde ou chalcogénure d'au moins un métal de transition, répond à la formulation suivante :

$$A'_x M_y B_\beta$$

où :

- A' représente au moins un métal alcalin choisi parmi Li et Na ;
- M représente au moins un métal choisi parmi Mn, Fe, Co et Ni ;
- B représente au moins un non-métal choisi parmi O et S ; et
- les paramètres x, y et $\beta$ satisfont aux inégalités suivantes, x étant de plus choisi dans le domaine de stabilité des composés :

$$0 < x \leq 1$$
$$y = 1$$
$$1{,}5 \leq \beta.$$

9. Elément mémristif selon la revendication 7 ou 8, dans lequel ledit composé d'insertion d'au moins un métal alcalin, de type oxyde ou chalcogénure d'au moins un métal de transition, est choisi parmi les suivants : $Na_xCoO_2$ $Li_xCoO_2$, $Li_xNiO_2$, $Li_xMn_4O_9$, $Li_xTiO_2$, $Li_{4+x}Ti_5O_{12}$, $Li_xV_2O_5$, $Li_xV_6O_{13}$, $Li_xNi_yCo_{(1-y)}O_2$, $Li_xFeO_2$, $Li_xMnO_2$ $Li_xMn_2O_4$, $Li_xMoO_3$ et $Li_xNi_{1/3}Mn_{1/3}Co_{1/3}O_2$, le paramètre x étant choisi dans le domaine de stabilité de ces composés.

10. Elément mémristif selon la revendication 9, dans lequel ledit composé d'insertion d'au moins un métal alcalin, de type oxyde ou chalcogénure d'au moins un métal de transition, est choisi parmi $Na_xCoO_2$ et $Li_xCoO_2$.

11. Elément mémristif selon l'une des revendications précédentes, dans lequel ledit composé d'insertion d'au moins un métal alcalin, de type oxyde ou chalcogénure d'au moins un métal de transition, présente une structure lamellaire.

12. Elément mémristif selon l'une des revendications précédentes, dans lequel au moins une parmi ladite première et ladite deuxième électrode est réalisée en silicium dégénéré.

13. Elément mémristif selon la revendication 12 dans lequel une parmi ladite première et ladite deuxième électrode est réalisée en silicium dégénéré, et ledit composé d'insertion d'au moins un métal alcalin est du $Li_xCoO_2$.

14. Elément mémristif selon l'une des revendications 1 à 11, dans lequel au moins une parmi ladite première et ladite deuxième électrode est réalisée en un matériau choisi parmi l'aluminium, le gallium, l'indium, l'antimoine, le bismuth, le cadmium, le zinc, l'étain, le plomb.

15. Mémoire électronique de type non volatile constituée par une pluralité d'éléments mémristifs (M11, M12...) selon l'une des revendications précédentes agencés de façon matricielle selon des lignes et des colonnes, tous les éléments d'une même ligne partageant une première électrode (15) commune, et tous les éléments d'une même colonne partageant une deuxième électrode (35) commune.

**Patentansprüche**

1.  Memristives Element (M), welches gebildet ist aus:

    - einer ersten Elektrode (10),
    - einer zweiten Elektrode (30) und
    - einem aktiven Bereich (20), welcher in direktem elektrischem Kontakt mit der besagten ersten und der besagten zweiten Elektrode ist,
    **dadurch gekennzeichnet, dass** der besagte aktive Bereich ausschließlich gebildet ist aus einer dünnen Schicht einer Einlagerungsverbindung mindestens eines Alkalimetalls, vom Oxid- oder Chalkogenid-Typ mindestens eines Übergangsmetalls, mit einer gleichzeitigen Leitfähigkeit elektronischer und ionischer Natur.

2.  Memristives Element gemäß Anspruch 1, wobei die besagte dünne Schicht auf einer Fläche der besagten ersten Elektrode angeordnet ist.

3.  Memristives Element gemäß einem der vorherigen Ansprüche, wobei die besagte erste Elektrode aus einer Fläche eines Entarteter-Halbleiter-Substrats und einer metallischen Schicht, welche auf einem isolierenden Substrat angeordnet ist, ausgewählt ist.

4.  Memristives Element gemäß einem der vorherigen Ansprüche, wobei die besagte zweite Elektrode aus einer metallischen Schicht gebildet ist, welche auf der besagten dünnen Schicht angeordnet ist.

5.  Memristives Element gemäß einem der vorherigen Ansprüche, wobei die besagte dünne Schicht eine polykristalline oder amorphe Struktur hat.

6.  Memristives Element gemäß einem der vorherigen Ansprüche, wobei die besagte dünne Schicht eine Dicke hat, welche kleiner oder gleich 10 $\mu$m ist und vorzugsweise zwischen 10 nm und 1 $\mu$m liegt.

7.  Memristives Element gemäß einem der vorherigen Ansprüche, wobei die besagte Einlagerungsverbindung mindestens eines Alkalimetalls, vom Oxid- oder Chalkogenid-Typ mindestens eines Übergangsmetalls, der folgenden Formulierung entspricht:

    $$A_x(M_1)_v(M_2)_w(M_3)_y(M_4)_zB_\beta$$

    wobei:

    - A ein oder mehrere Alkalimetalle darstellt,
    - $M_1$ mindestens ein Metall darstellt, welches aus Ag und Cu ausgewählt ist,
    - $M_2$ mindestens ein Metall darstellt, welches aus Ti, Mn, Fe und Cu ausgewählt ist,
    - $M_3$ mindestens ein Metall darstellt, welches aus Ti, V, Cr, Mn, Fe, Co, Ni, Mo und Ta ausgewählt ist,
    - $M_4$ mindestens ein Metall darstellt, welches aus Ti, V, Mn, Co, Ni, Zr und Ta ausgewählt ist,
    - B mindestens ein Nichtmetall darstellt, welches aus O, S, Se und Te ausgewählt ist,
    - die Parameter x, v, w, y, z und $\beta$ die folgenden Ungleichungen erfüllen, wobei x zusätzlich in der Stabilitätsdomäne der Verbindungen ausgewählt ist:

        $0 < x \le 1$
        $0 \le v \le 1$
        $0 \le w < 1$
        $0 \le y \le 1$
        $0 \le z < 1$
        $1,5 \le \beta$

    - die Parameter x, v, w, y, z gleichermaßen die folgende Gleichung erfüllen: v + w + y + z = 1.

8. Memristives Element gemäß Anspruch 7, wobei die besagte Einlagerungsverbindung mindestens eines Alkalimetalls, vom Oxid- oder Chalkogenid-Typ mindestens eines Übergangsmetalls, der folgenden Formulierung entspricht:

$$A'_x M_y B_\beta$$

wobei:

- A' mindestens ein Alkalimetall darstellt, welches aus Li und Na ausgewählt ist,
- M mindestens ein Metall darstellt, welches aus Mn, Fe, Co und Ni ausgewählt ist,
- B mindestens ein Nichtmetall darstellt, welches aus O und S ausgewählt ist, und
- die Parameter x, y und $\beta$ die folgenden Ungleichungen erfüllen, wobei x zusätzlich in der Stabilitätsdomäne der Verbindungen ausgewählt ist:

$$0 < x \leq 1$$
$$y = 1$$
$$1{,}5 \leq \beta.$$

9. Memristives Element gemäß Anspruch 7 oder 8, wobei die besagte Einlagerungsverbindung mindestens eines Alkalimetalls, vom Oxid- oder Chalkogenid-Typ mindestens eines Übergangsmetalls, aus den folgenden ausgewählt ist: $Na_x CoO_2$, $Li_x CoO_2$, $Li_x NiO_2$, $Li_x Mn_4 O_9$, $Li_x TiO_2$, $Li_{4+x} Ti_5 O_{12}$, $Li_x V_2 O_5$, $Li_x V_6 O_{13}$, $Li_x Ni_y Co_{(1-y)} O_2$, $Li_x FeO_2$, $Li_x MnO_2$, $Li_x Mn_2 O_4$, $Li_x MoO_3$ und $Li_x Ni_{1/3} Mn_{1/3} Co_{1/3} O_2$, wobei der Parameter x in der Stabilitätsdomäne dieser Verbindungen ausgewählt ist.

10. Memristives Element gemäß Anspruch 9, wobei die besagte Einlagerungsverbindung mindestens eines Alkalimetalls, vom Oxid- oder Chalkogenid-Typ mindestens eines Übergangsmetalls, aus $Na_x CoO_2$ und $Li_x CoO_2$ ausgewählt ist.

11. Memristives Element gemäß einem der vorherigen Ansprüche, wobei die besagte Einlagerungsverbindung mindestens eines Alkalimetalls, vom Oxid- oder Chalkogenid-Typ mindestens eines Übergangsmetalls, eine lamellare Struktur hat.

12. Memristives Element gemäß einem der vorherigen Ansprüche, wobei mindestens eine von der besagten ersten und der besagten zweiten Elektrode aus entartetem Silizium verwirklicht ist.

13. Memristives Element gemäß Anspruch 12, wobei eine von der besagten ersten und der besagten zweiten Elektrode aus entartetem Silizium verwirklicht ist und die besagte Einlagerungsverbindung mindestens eines Alkalimetalls aus $Li_x CoO_2$ ist.

14. Memristives Element gemäß einem der Ansprüche 1 bis 11, wobei mindestens eine von der besagten ersten und der besagten zweiten Elektrode aus einem Material verwirklicht ist, welches aus Aluminium, Gallium, Indium, Antimon, Wismut, Kadmium, Zink, Zinn und Blei ausgewählt ist.

15. Elektronischer Speicher vom nicht-flüchtigen Typ, welcher aus einer Mehrzahl von memristiven Elementen (M11, M12...) gemäß einem der vorherigen Ansprüche gebildet ist, welche auf Matrixweise entlang Zeilen und Spalten angeordnet sind, wobei alle Elemente einer gleichen Zeile eine gemeinsame erste Elektrode (15) teilen und wobei alle Elemente einer gleichen Spalte eine gemeinsame zweite Elektrode (35) teilen.

**Claims**

1. A memristive element (M) formed by:

- a first electrode (10);
- a second electrode (30); and
- an active region (20) making direct electrical contact with said first and second electrodes,
**characterized in that** said active region is exclusively constituted by a thin film of an insertion compound of at least one alkali metal, made of an oxide or chalcogenide of at least one transition metal, exhibiting conductivity that is both electronic and ionic in nature.

2. The memristive element as claimed in claim 1, in which said thin film is deposited on a surface of said first electrode.

3. The memristive element as claimed in either one of the preceding claims, in which said first electrode is chosen from a surface of a degenerate semiconductor substrate and a metallic film deposited on an insulating substrate.

4. The memristive element as claimed in one of the preceding claims, in which said second electrode is formed by a metallic film deposited on said thin film.

5. The memristive element as claimed in one of the preceding claims, in which said thin film has a polycrystalline or amorphous structure.

6. The memristive element as claimed in one of the preceding claims, in which said thin film is 10 $\mu$m or less in thickness, and preferably between 10 nm and 1 $\mu$m in thickness.

7. The memristive element as claimed in one of the preceding claims, in which said insertion compound of at least one alkali metal, made of an oxide or chalcogenide of at least one transition metal, has the following formula:

$$A_x(M_1)_v(M_2)_w(M_3)_y(M_4)_zB_\beta$$

where:

- A represents one or more alkali metals;
- $M_1$ represents at least one metal chosen from Ag and Cu;
- $M_2$ represents at least one metal chosen from Ti, Mn, Fe and Cu;
- $M_3$ represents at least one metal chosen from Ti, V, Cr, Mn, Fe, Co, Ni, Mo and Ta;
- $M_4$ represents at least one metal chosen from Ti, V, Mn, Co, Ni, Zr and Ta;
- B represents at least one nonmetal chosen from O, S, Se and Te;
- the parameters x, v, w, y, z and $\beta$ satisfy the following inequalities, x in addition being chosen in the stability field of the compounds:

$0 < x \leq 1$
$0 \leq v \leq 1$
$0 \leq w < 1$
$0 \leq y \leq 1$
$0 \leq z < 1$
$1.5 \leq \beta$; and

- the parameters x, v, w, y, z also satisfy the equality: v + w + y + z = 1.

8. The memristive element as claimed in claim 7, in which said insertion compound of at least one alkali metal, made of an oxide or chalcogenide of at least one transition metal, has the following formula:

$$A'_xM_yB_\beta$$

where:

- A' represents at least one alkali metal chosen from Li and Na;
- M represents at least one metal chosen from Mn, Fe, Co and Ni;
- B represents at least one nonmetal chosen from O and S; and
- the parameters x, y and $\beta$ satisfy the following inequalities, x in addition being chosen in the stability field of the compounds:

$0 < x \leq 1$
$y = 1$
$1.5 \leq \beta$.

9. The memristive element as claimed in either of claims 7 and 8, in which said insertion compound of at least one alkali metal, made of an oxide or chalcogenide of at least one transition metal, is chosen from the following: $Na_xCoO_2$,

$Li_xCoO_2$, $Li_xNiO_2$, $Li_xMn_4O_9$, $Li_xTiO_2$, $Li_{4+x}Ti_5O_{12}$, $Li_xV_2O_5$, $Li_xV_6O_{13}$, $Li_xNi_yCo_{(1-y)}O_2$, $Li_xFeO_2$, $Li_xMnO_2$, $Li_xMn_2O_4$, $Li_xMoO_3$ and $Li_xNi_{1/3}Mn_{1/3}Co_{1/3}O_2$, the parameter x being chosen in the stability field of these compounds.

10. The memristive element as claimed in claim 9, in which said insertion compound of at least one alkali metal, made of an oxide or chalcogenide of at least one transition metal, is chosen from $Na_xCoO_2$ and $Li_xCoO_2$.

11. The memristive element as claimed in one of the preceding claims, in which said insertion compound of at least one alkali metal, made of an oxide or chalcogenide of at least one transition metal, has a lamellar structure.

12. The memristive element as claimed in one of the preceding claims, in which at least one of said first and said second electrodes is made of degenerate silicon.

13. The memristive element as claimed in claim 12, in which one of said first and said second electrodes is made of degenerate silicon, and said insertion compound of at least one alkali metal is $Li_xCoO_2$.

14. The memristive element as claimed in one of claims 1 to 11, in which at least one of said first and said second electrodes is made of a material chosen from aluminum, gallium, indium, antimony, bismuth, cadmium, zinc, tin, and lead.

15. A nonvolatile electronic memory formed from a plurality of memristive elements (M11, M12, etc.) as claimed in one of the preceding claims, arranged in a matrix in rows and columns, all the elements of a given row sharing a common first electrode (15), and all the elements of a given column sharing a common second electrode (35) .

Fig. 1

Fig. 2

Fig. 3

Fig. 4A

Fig. 4B

## RÉFÉRENCES CITÉES DANS LA DESCRIPTION

### Documents brevets cités dans la description

- US 20080079029 A
- US 7763880 B
- US 7417271 B
- WO 2010074689 A

- US 2010102289 A
- WO 2009122567 A
- WO 2008145864 A
- EP 1860713 A

### Littérature non-brevet citée dans la description

- **L. O. CHUA.** Memristor - The Missing Circuit Element. *IEEE Transactions on Circuit Theory,* 1971, vol. CT-18, 507-519
- **J. BORGHETTI et al.** 'Memristive' switches enable 'stateful' logic operations via material implication. *Nature,* 08 Avril 2010, vol. 464, 873-876
- **F. ABGALL.** Switching phenomena in titanium oxide thin films. *Solid-State Electronics,* 1968, vol. 11, 535-541
- **D. B. STRUKOV et al.** The missing memristor found. *Nature,* 01 Mai 2008, vol. 453, 80-83
- **R. WASER.** Nanoionics-based resistive switching memories. *Nature materials,* Novembre 2007, vol. 6, 833-840

- Redox-Based Resistive Switching Memories - Nanoionic Mechanisms, Prospects, and Challenges. *Advanced Materials,* 2009, vol. 21, 2632-2663
- **J. J. YANG et al.** *Nanotechnol,* 2009, vol. 20, 215201
- **O. SCHNEEGANS ; A. MORADPOUR ; O. DRAGOS ; S. FRANGER ; N. DRAGOE ; L. PINSARD-GAUDART ; P. CHRETIEN ; A. REVCOLEVSCHI.** *J. Amer. Chem. Soc,* 2007, vol. 129, 7482
- **O. SCHNEEGANS ; A. MORADPOUR ; L. BOYER ; D. BALLUTAUD.** *J. Phys. Chem. B,* 2004, vol. 108, 9882